# FASCICULE DE BREVET EUROPEEN

(11) **EP 3 467 151 B1**
(45) Date de publication et mention de la délivrance du brevet: **17.06.2020**
(21) Numéro de dépôt: 17195237.7
(22) Date de dépôt: 06.10.2017
(51) Int. Cl.: C25D 1/00, C03C 4/04, G03F 7/004, C25D 1/10

(54) **MOULE POUR GALVANOPLASTIE ET SON PROCÉDÉ DE FABRICATION**
FORM FÜR GALVANOPLASTIK, UND IHR HERSTELLUNGSVERFAHREN
ELECTROPLATING MOULD AND METHOD FOR MANUFACTURING SAME

(43) Date de publication de la demande: 10.04.2019
(73) Titulaire: Nivarox-FAR S.A., 2400 Le Locle (CH)
(72) Inventeur: Verardo, Marco, 2336 Les Bois (CH); Gandelhman, Alex, 2000 Neuchâtel (CH); Chabloz, Martial, 2000 Neuchâtel (CH); Cusin, Pierre, 1423 Villars-Burquin (CH)
(74) Mandataire: ICB SA

(56) Documents cités:
- CH-B1- 704 955
- FR-A1- 2 966 845
- US-A1- 2004 241 965
- US-A1- 2015 277 047
- US-A1- 2016 340 229

## Description

### Domaine de l'invention

L'invention se rapporte à un moule destiné à fabriquer une pièce de micromécanique par galvanoplastie ainsi que son procédé de fabrication.

### Arrière plan de l'invention

La galvanoplastie est utilisée et connue depuis longtemps. Les procédés du type LIGA (abréviation très connue provenant de l'allemand « röntgenLIthographie, Galvanoformung & Abformung ») développés dans les années 80 se sont révélés intéressants pour la fabrication de microstructures métalliques de hautes précisions.

Dans son principe la technique LIGA consiste à déposer sur un substrat conducteur ou revêtu d'une couche conductrice, une couche d'une résine photosensible, à effectuer à travers un masque correspondant au contour de la microstructure désirée une irradiation X au moyen d'un synchrotron; à développer, c'est-à-dire à éliminer par des moyens physiques ou chimiques les portions de la couche de résine photosensible non irradiées afin de définir un moule ayant le contour de la microstructure, à déposer galvaniquement un métal, typiquement du nickel, dans le moule en résine photosensible puis à éliminer le moule pour libérer la microstructure.

La qualité des microstructures obtenues ne prête pas à critique, mais la nécessité de mettre en œuvre un équipement coûteux (synchrotron) rend cette technique peu compatible avec une production de masse de microstructures devant avoir un faible coût unitaire.

C'est pourquoi sur la base de ce procédé LIGA ont été développées des procédé analogues mais utilisant des résines photosensibles aux UV. Un tel procédé est par exemple décrit dans la publication de A.B. Frazier et al., intitulée « Metallic Microstructures Fabricated Using Photosensitive Polyimide Electroplating Molds", Journal of Microelectromechanical systems, Vol. 2, N deg. 2, June 1993 pour la fabrication de structures métalliques par électrodéposition de métal dans des moules en résine photosensible à base de polyimide. Ce procédé comprend les étapes suivantes :
- se munir d'un substrat comportant une surface conductrice d'amorçage pour une étape ultérieure d'électrodéposition,
- appliquer sur ladite surface conductrice d'amorçage une couche de résine photosensible (polyimide),
- irradier par UV la couche de résine photosensible à travers un masque correspondant au contour de la microstructure désirée,
- développer en dissolvant les parties non irradiées de la couche de résine photosensible de façon à obtenir un moule en résine photosensible,
- déposer galvaniquement du nickel dans la partie ouverte du moule jusqu'à la hauteur de celui-ci,
- séparer la structure métallique obtenue du substrat, et
- éliminer le moule en résine photosensible.

Ce procédé est très exploité dans le domaine de l'horlogerie pour la fabrication de ses composants de précision. Or il s'avère qu'au nombre des composants horlogers réalisés, bon nombre comporte une fonction « ressort », ressort travaillant dans le plan du composant ou du mouvement. La combinaison des paramètres « épaisseur du composant - raideur de ressort recherchée » peut ainsi conduire à des géométries de lames de ressorts très étroites (de quelques dizaines de microns, voire moins) pour des épaisseurs de plusieurs centaines de microns.

De façon similaire, il arrive que le design des composants nécessite de pouvoir définir des fentes étroites entre deux parties du composant, une mobile, l'autre fixe, par exemple.

Dans ces deux cas, le procédé conventionnel de LIGA-UV rencontre des limites, tant en terme de facteur d'aspect (rapport hauteur/largeur) du
gap à remplir de métal lors de la croissance, que du facteur d'aspect de résine séparant deux géométries proches.

En outre, garantir que la résine photosensible conserve ses géométries (verticalité, taille,...) dans le bain galvanique reste délicat, ce qui handicape la fabrication robuste de ces composants horlogers spécifiques.

Il existe donc un besoin pour un procédé permettant de s'affranchir de tels inconvénients.

On connaît également du document FR 2 966 845 un procédé de fabrication de micro-composant métallique comportant l'élaboration d'un moule en silicium par gravure d'un substrat comportant une couche métallique de manière à réaliser une cavité laissant à nu au moins une partie de la couche métallique.

On connaît aussi du document US 2004/0241965 un procédé d'électrodéposition dans un moule en verre pour former des microélectrodes ayant un diamètre compris entre 1 et 100 microns et un facteur d'aspect aussi élevé que 2000.

### Résumé de l'invention

La présente invention a pour but de remédier aux inconvénients liés au procédé conventionnel de LIGA-UV, en proposant un moule alternatif permettant de s'affranchir des risques de déformation de la résine formant le moule utilisé dans ledit procédé conventionnel de LIGA-UV.

Un autre but de l'invention est de proposer un moule permettant de réaliser des pièces de micromécanique comportant des géométries à haut facteur d'aspect par électroformage.

A cet effet, l'invention se rapporte à un procédé de fabrication d'un moule comportant les étapes suivantes :
a) se munir d'un premier substrat en verre photosensible d'épaisseur au moins égale à la hauteur du moule
b) illuminer ledit premier substrat par rayons UV à travers un masque dont les fenêtres correspondent à l'empreinte du moule pour créer des zones illuminées
c) effectuer un traitement thermique du premier substrat obtenu à l'étape b) pour cristalliser les zones illuminées
d) se munir d'un second substrat présentant au moins une couche conductrice en surface
e) assembler le premier substrat obtenu à l'étape c) au second substrat de sorte que la couche conductrice se situe entre le premier et le second substrats
f) éliminer les zones illuminées et cristallisées du premier substrat de manière à faire apparaitre la couche conductrice afin de former au moins une cavité dont les parois latérales et le fond occupé par la couche conductrice constituent ledit moule.

Un tel procédé permet de réaliser un moule en verre, plus rigide et insensible aux effets du bain de croissance galvanique utilisé pour former une pièce de micromécanique à partir dudit moule.

L'invention se rapporte également à un procédé de fabrication par galvanoplastie d'une pièce de micromécanique, comprenant les étapes suivantes :
g) fabriquer un moule de ladite pièce de micromécanique selon le procédé de fabrication d'un moule défini ci-dessus
h) remplir le moule d'un matériau métallique par croissance galvanique à partir de la couche conductrice pour former ladite pièce de micromécanique
i) libérer la pièce de micromécanique obtenue à l'étape h) de son moule.

L'invention se rapporte également à une plaque de moulage destinée à fabriquer au moins une pièce de micromécanique par galvanoplastie, comportant un premier substrat en verre photosensible d'épaisseur au moins égale à la hauteur de la pièce de micromécanique, un second substrat solidaire du premier substrat, au moins une couche conductrice prévue entre les premier et second substrats, le premier substrat comportant au moins un moule de la pièce micromécanique constitué par une cavité formée dans ledit premier substrat et dont le fond est occupé par la couche conductrice, permettant de déposer par croissance galvanique un matériau métallique dans ladite cavité pour former ladite pièce de micromécanique.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 5 sont des représentations des étapes successives d'un procédé de fabrication d'une pièce de micromécanique selon un premier mode de réalisation de l'invention ; et
- les figures 6 à 11 sont des représentations des étapes successives d'un procédé de fabrication d'une pièce de micromécanique selon un deuxième mode de réalisation de l'invention.

### Description détaillée des modes de réalisation préférés

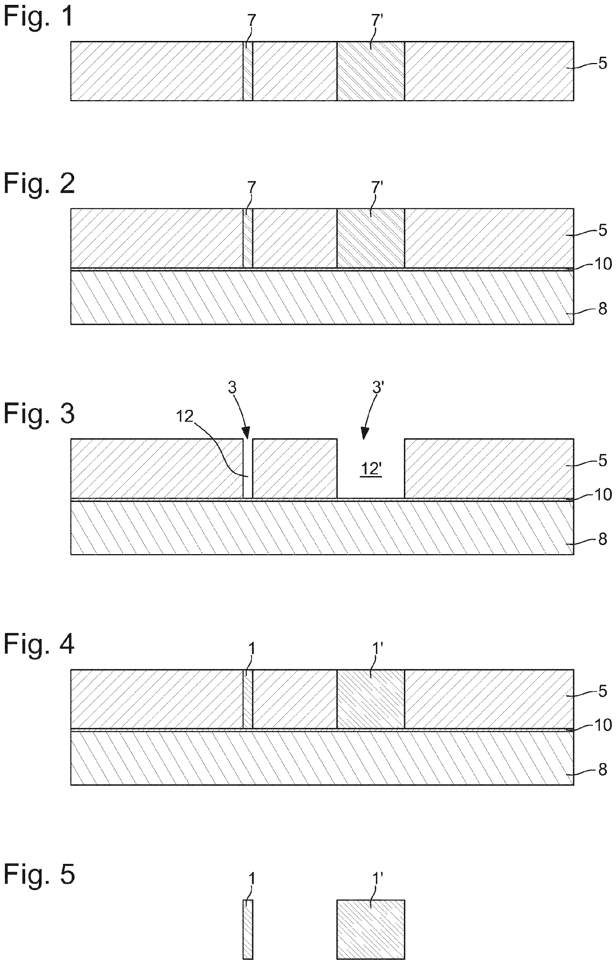

En référence aux figures 1 à 5, la présente invention se rapporte à un procédé de fabrication d'une pièce de micromécanique 1, 1' par galvanoplastie. Le procédé comporte, préférentiellement, un procédé de fabrication d'un moule 3, 3', suivi d'une étape de galvanoplastie et d'une étape de libération de la pièce 1, 1' dudit moule 3, 3' respectivement.

Le procédé de fabrication d'un moule 3, 3' selon l'invention comporte des étapes successives destinées à fabriquer un moule 3, 3' :
Une première étape a) du procédé de fabrication du moule 3, 3' consiste à se munir d'un premier substrat 5 en verre photosensible d'épaisseur au moins égale à la hauteur du moule.

Un tel verre photosensible est par exemple disponible chez Schott A.G. sous la marque Foturan®, chez Hoya Corp. sous la référence PEG3® ou chez LifeBioScience Inc. sous la marque Apex™.

Avantageusement selon l'invention, l'utilisation de verre photosensible permet de générer dans le verre une plus grande variété de géométries que le gravage de matériaux à base de silicium ou de céramique.

La seconde étape b) du procédé de fabrication du moule 3, 3' consiste à illuminer le premier substrat 5 par rayons UV, à une longueur d'onde correspondant au verre photosensible, à travers un masque opaque à ladite longueur d'onde et dont les fenêtres correspondent respectivement aux empreintes des moules à réaliser pour créer des zones illuminées 7, 7'. Ainsi, suivant la quantité, l'orientation et la distribution de l'illumination, seules les zones 7, 7' du premier substrat 5 exposées aux rayons UV sont structurées pour former les empreintes des moules à réaliser. La source d'illumination peut par exemple être une lampe UV dont le pic de distribution spectral est situé entre 200 et 400 nm.

La troisième étape c) du procédé de fabrication du moule 3, 3' consiste à effectuer un traitement thermique du premier substrat 5 obtenu à l'étape b) pour cristalliser les zones illuminées 7, 7', comme représenté sur la figure 1. Ce traitement thermique est effectué à haute température, de préférence entre 500°C et 600°C. Ce traitement thermique permet de rendre les zones illuminées 7, 7' plus sélectives pour leur élimination selon l'étape f) comme on le verra ci-après.

La quatrième étape d) du procédé de fabrication du moule 3, 3' consiste à se munir d'un second substrat 8, ledit substrat présentant au moins une couche conductrice 10 en surface. Avantageusement, la couche conductrice est formée par un dépôt sur le second substrat 8 d'une couche 10 d'un matériau métallique choisi parmi le groupe comprenant le chrome, le titane, et l'or, l'or étant préféré. La couche conductrice 10 présente de préférence une épaisseur comprise entre 0.1 µm et 0.5 µm.

La couche métallique 10 présente le double avantage d'une part d'être conductrice pour permettre la mise en œuvre de l'étape h) d'électrodéposition et d'autre part de permettre l'assemblage par soudure du second substrat au premier substrat selon l'étape e) comme cela sera décrit ci-après.

Le second substrat 8 est réalisé dans un matériau de préférence résistant aux attaques acides. Avantageusement, le second substrat 8 est à base de silicium.

La cinquième étape e) du procédé de fabrication du moule 3, 3' consiste à assembler le premier substrat 5 comprenant les zones 7,7' illuminées et cristallisées, tel qu'obtenu à l'étape c), au second substrat 8 de sorte que la couche conductrice 10 se situe entre le premier substrat 5 et le second substrat 8, comme représenté sur la figure 2.

Dans cette première variante de l'invention, l'assemblage des deux substrats 5 et 8 est réalisé par soudure par l'intermédiaire de la couche conductrice métallique 10.

La sixième étape f) du procédé de fabrication du moule 3, 3' consiste éliminer les zones 7, 7' illuminées à l'étape b) et cristallisées à l'étape c) du premier substrat 5, de manière à faire apparaitre la couche conductrice 10 afin de former au moins une cavité 12, 12' dont les parois latérales verticales et le fond occupé par la couche conductrice 10 constituent ledit moule 3, 3', comme représenté sur la figure 3.

D'une manière avantageuse, l'étape f) d'élimination des zones illuminées et cristallisées 7, 7' du premier substrat 5 est réalisée par attaque chimique, de préférence par dissolution par de l'acide fluorhydrique. Par exemple, cette attaque chimique peut être effectuée dans un bain d'acide fluorhydrique à environ 10%, à température ambiante et sous ultrasons.

Un moule 3, 3' dont les parois latérales sont en verre photosensible est ainsi réalisé.

Il est à noter que, contrairement à la pratique usuelle, le procédé selon l'invention ne comprend pas d'étape finale de cristallisation à plus haute température (600-700°C) pour totalement cristalliser le verre photosensible restant.

La présente invention concerne également un procédé de fabrication par galvanoplastie d'une pièce de micromécanique métallique 1,1'. Ledit procédé comprend une étape g) qui consiste à fabriquer un moule 3, 3', de ladite pièce de micromécanique 1, 1' selon le procédé de fabrication d'un moule 3, 3' décrit ci-dessus. L'étape h) suivante consiste à remplir le moule 3, 3' d'un matériau métallique par croissance galvanique à partir de la couche conductrice 10 pour former ladite pièce de micromécanique 1, 1', comme représenté sur la figure 4.

Le matériau métallique est avantageusement choisi parmi le groupe comprenant le nickel, le cuivre, l'or ou l'argent, et leurs alliages, comme alliage l'or-cuivre, le nickel-cobalt, le nickel-fer, et le nickel-phosphore.

De préférence, la hauteur du moule est légèrement supérieure à la hauteur de la pièce à fabriquer et est égale à l'épaisseur du premier substrat 5. La hauteur de la pièce de micromécanique est comprise entre 50 µm et 500 µm. L'utilisation d'un substrat en verre photosensible permet de réaliser, selon l'épaisseur, des pièces dont la largeur minimale de certaines géométries peut être comprise entre 10 µm et 30 µm de sorte que ces géométries particulières de pièces de micromécaniques obtenues selon le procédé de l'invention peuvent présenter un haut facteur d'aspect compris entre 1 et 20. Une telle pièce de micromécanique 1, 1' pourrait, par exemple, être un ressort de rappel, un sautoir, un système monobloc de guidage flexible, une géométrie compliante de rattrapage de jeu, etc.

Les conditions d'électroformage, notamment la composition des bains, la géométrie du système, les tensions et densités de courant, sont choisis pour chaque métal ou alliage à électro-déposer selon les techniques bien connues dans l'art de l'électroformage (cf. par exemple Di Bari G.A. "electroforming" Electroplating Engineering Handbook 4th Edition rédigée par L.J. Durney, publié par Van Nostrand Reinhold Compagny Inc., N.Y. USA 1984).

Il est possible, dans une étape h') subséquente, de procéder à la mise à niveau du dépôt métallique électro-formé avec le premier substrat 5. Cette étape peut se faire par abrasion et polissage afin d'obtenir directement des microstructures ayant une surface supérieure plane présentant notamment un état de surface compatible avec les exigences de l'industrie horlogère pour la réalisation de mouvement de haut de gamme.

L'étape i) suivante illustrée à la figure 5 consiste à libérer la pièce de micromécanique 1, 1' obtenue à l'étape h) ou h') de son moule 3, 3'. A cet effet, on peut exploiter des procédés de gravure chimiques (par exemple HF pour le verre photosensible, KOH pour le silicium).

La pièce de micromécanique 1, 1' ainsi libérée peut être utilisée directement ou le cas échéant après un usinage approprié.

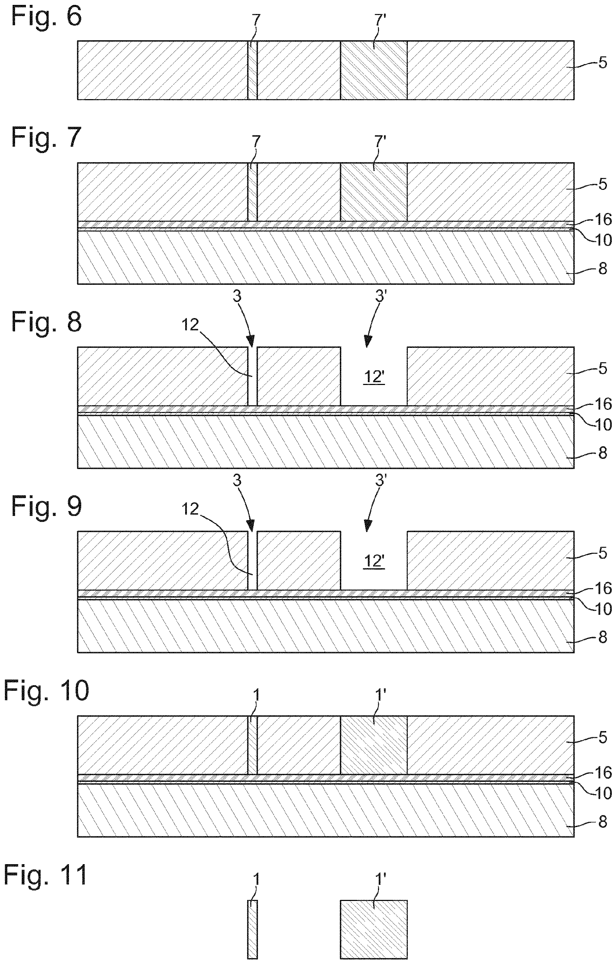

Les figures 6 à 11 représentent une seconde variante de mise en œuvre du procédé de fabrication d'un moule selon l'invention. Ce procédé est pratiquement identique à la première variante décrite ci-dessus, à l'exception des étapes e) et f). Le premier substrat 5 comprenant les zones illuminées et cristallisées 7, 7', comme représenté sur la figure 6, est obtenu selon les étapes a) à c) telles que décrites ci-dessus. Dans cette seconde variante, l'assemblage du premier substrat 5 avec le second substrat 8 selon l'étape e) est réalisée par soudure temporaire du premier substrat 5 avec le second substrat 8 au moyen d'une couche de résine 16 prévue entre ledit premier substrat 5 et la couche conductrice 10, comme le montre la figure 7. Pour ce faire, on peut utiliser par exemple le même type de résine que celui utilisé dans les procédés de fabrication de semiconducteurs pour des étapes de soudage temporaire. La couche de résine 16 visée présente une épaisseur comprise entre 2 µm et 10 µm.

En outre, dans cette seconde variante, l'étape f) comprend l'élimination des zones illuminées et cristallisées 7, 7' du premier substrat 5 de manière à faire apparaitre la couche de résine 16 comme le montre la figure 8. Puis l'étape f) comprend une sous-étape f') d'élimination de la couche de résine 16 apparue dans le fond de la cavité 12, 12' après l'élimination des zones 7, 7' illuminées et cristallisées du premier substrat 5, de manière à faire apparaitre la couche conductrice 10, comme le montre la figure 9.

La pièce de micromécanique 1, 1' est ensuite réalisée comme dans le procédé de fabrication par galvanoplastie décrit ci-dessus, comme le montrent les figures 10 et 11. L'étape i) de libération de la pièce 1, 1' de son moule 3, 3' s'effectue par des procédés de gravure chimiques (par exemple HF pour le verre photosensible, KOH pour le silicium).

Les procédés selon la présente invention permettent de réaliser des pièces de micromécanique présentant des géométries étroites et rigides avec une haute précision, en mode « batch ».

En effet, d'une manière particulièrement avantageuse, plusieurs moules 3, 3' sont réalisés sur le même premier substrat 5, 5'. Ces moules ne sont pas forcément identiques entre eux. On obtient alors une plaque de moulage 14 comme illustrée à la figure 3.

Cette plaque que moulage 14 est destinée à fabriquer au moins une pièce de micromécanique 1, 1' par galvanoplastie. Selon l'invention, elle comporte un premier substrat 1, 1' en verre photosensible d'épaisseur au moins égale à la hauteur de la pièce de micromécanique 1, 1', un second substrat 8 solidaire du premier substrat 5, au moins une couche conductrice 10 prévue entre les premier et second substrats 5, 8, et éventuellement une couche de résine 16 prévue entre le premier substrat 5 et la couche conductrice 10. Le premier substrat 5 comporte au moins un moule 3, 3' de la pièce micromécanique 1, 1' constitué par une cavité 12, 12' formée dans ledit premier substrat 5 et dont le fond est occupé par la couche conductrice 10, permettant de déposer par croissance galvanique un matériau métallique dans ladite cavité 12, 12' pour former ladite pièce de micromécanique 1, 1'. Les premier et second substrats 5 et 8, la couche conductrice 10 et la couche de résine 16 sont tels que défini ci-dessus.

De plus, les moules obtenus selon l'invention sont en verre photosensible, qui est plus rigide qu'une résine utilisée traditionnellement pour former des moules, et insensible aux effets des bains de croissance galvanique. Le procédé de fabrication des pièces de micromécanique selon l'invention est donc particulièrement robuste, notamment pour la fabrication de pièces à haut facteur d'aspect.

Les procédés selon l'invention permettent également de démarrer facilement la croissance galvanique selon l'étape h) grâce à l'utilisation d'une couche conductrice 10 de bonne qualité en fond de moule 3, 3'.

En outre, le procédé de fabrication des pièces de micromécanique selon l'invention est simple à mettre en œuvre car il ne nécessite pas de dépôt localisé et complexe de métal (par masque-chablon) pour former la couche de démarrage de la croissance galvanique.

Enfin, le procédé de fabrication des pièces de micromécanique selon l'invention permet d'éviter des géométries gravées par DRIE Bosch®. Il ne se produit donc pas de scalloping qui nécessiterait une étape supplémentaire de lissage.

## Revendications

1. Procédé de fabrication d'un moule (3, 3') comportant les étapes suivantes :
a) se munir d'un premier substrat (5) en verre photosensible d'épaisseur au moins égale à la hauteur du moule (3, 3')
b) illuminer ledit premier substrat (5) par rayons UV à travers un masque dont les fenêtres correspondent à l'empreinte du moule (3, 3') pour créer des zones illuminées (7, 7')
c) effectuer un traitement thermique du premier substrat (5) obtenu à l'étape b) pour cristalliser les zones illuminées (7, 7')
d) se munir d'un second substrat (8) présentant au moins une couche conductrice (10) en surface
e) assembler le premier substrat (5) obtenu à l'étape c) au second substrat (8) de sorte que la couche conductrice (10) se situe entre le premier (5) et le second (8) substrats
f) éliminer les zones (7, 7') illuminées et cristallisées du premier substrat (5) de manière à faire apparaitre la couche conductrice (10) afin de former au moins une cavité (12, 12') dont les parois latérales et le fond occupé par la couche conductrice (10) constituent ledit moule (3, 3').

2. Procédé selon la revendication 1, **caractérisé en ce que** le second substrat (8) est à base de silicium.

3. Procédé selon l'une des revendications précédentes, **caractérisé en ce que** la couche conductrice (10) est formée par un dépôt sur le second substrat (8) d'une couche d'un matériau métallique choisi parmi le groupe comprenant le chrome, le titane et l'or.

4. Procédé selon l'une des revendications précédentes, **caractérisé en ce que** l'étape e) d'assemblage des premier (5) et second (8) substrats est réalisé par soudure de la couche conductrice (10) du second substrat (8) au premier substrat (5).

5. Procédé selon l'une des revendications 1 à 3, **caractérisé en ce que** l'étape e) d'assemblage des premier (5) et second (8) substrats est réalisée par soudure du premier substrat (5) avec le second substrat (8) au moyen d'une couche de résine (16) prévue entre le premier substrat (5) et la couche conductrice (10).

6. Procédé selon la revendication 5, caractérisé en ce l'étape f) comprend une sous-étape f) d'élimination de la couche de résine (16) apparue dans la cavité (12, 12') après l'élimination des zones illuminées et cristallisées (7, 7') du premier substrat (5), de manière à faire apparaitre la couche conductrice (10).

7. Procédé selon l'une des revendications précédentes, **caractérisé en ce que** l'étape f) d'élimination des zones illuminées et cristallisées (7, 7') du premier substrat (5) est réalisée par attaque chimique, de préférence par dissolution par de l'acide fluorhydrique.

8. Procédé selon l'une des revendications précédentes, **caractérisé en ce que** plusieurs moules (3, 3') sont réalisés sur le même premier substrat (5).

9. Procédé de fabrication par galvanoplastie d'une pièce de micromécanique métallique (1, 1'), **caractérisé en ce qu'**il comprend les étapes suivantes :
g) fabriquer un moule (3, 3') de ladite pièce de micromécanique (1, 1') selon le procédé de fabrication d'un moule (3, 3') conforme à l'une des revendications 1 à 8
h) remplir le moule (3, 3') d'un matériau métallique par croissance galvanique à partir de la couche conductrice (10) pour former ladite pièce de micromécanique (1, 1')
i) libérer la pièce de micromécanique (1, 1') obtenue à l'étape h) de son moule (3, 3').

10. Plaque de moulage (14) destinée à fabriquer au moins une pièce de micromécanique (1, 1') par galvanoplastie, ladite plaque de moulage (14) comportant un premier substrat (5) d'épaisseur au moins égale à la hauteur de la pièce de micromécanique (1, 1'), un second substrat (8) solidaire du premier substrat (5), au moins une couche conductrice (10) située entre les premier (5) et second (8) substrats, le premier substrat (5) comportant au moins un moule (3, 3') de la pièce micromécanique (1, 1') constitué par une cavité (12, 12') formée dans ledit premier substrat (5) et dont le fond est occupé par la couche conductrice (10), permettant de déposer par croissance galvanique un matériau métallique dans ladite cavité (12, 12') pour former ladite pièce de micromécanique (3, 3'), ladite plaque de moulage (14) étant **caractérisée en ce que** le premier substrat (5) est en verre photosensible.

11. Plaque de moulage (14) selon la revendication 10, **caractérisée en ce que** le second substrat (8) est à base de silicium.

12. Plaque de moulage (14) selon l'une des revendications 10 et 11, **caractérisée en ce que** la couche conductrice (10) est une couche d'un matériau métallique choisi parmi le groupe comprenant le chrome, le titane et l'or.

13. Plaque de moulage (14) selon l'une des revendications 10 à 12, **caractérisée en ce qu'**elle comprend une couche de résine (16) prévue entre le premier substrat (5) et la couche conductrice (10).

## Patentansprüche

1. Verfahren zur Herstellung einer Form (3, 3'), umfassend die folgenden Schritte:
a) Bereitstellen eines ersten Substrats (5) aus lichtempfindlichem Glas mit einer Dicke, die mindestens der Höhe der Form (3, 3') entspricht
b) Beleuchten des ersten Substrats (5) mit UV-Strahlen durch eine Maske, deren Fenster dem Formhohlraum (3, 3') entsprechen, um beleuchtete Bereiche (7, 7') zu erzeugen
c) Durchführen einer Wärmebehandlung des in Schritt b) erhaltenen ersten Substrats (5), um die beleuchteten Bereiche (7, 7') auszukristallisieren
d) Bereitstellen eines zweiten Substrats (8) mit mindestens einer leitenden Schicht (10) auf seiner Oberfläche
e) Verbinden des in Schritt c) erhaltenen ersten Substrats (5) mit dem zweiten Substrat (8), derart, dass sich die leitende Schicht (10) zwischen dem ersten (5) und dem zweiten (8) Substrat befindet
f) Entfernen der beleuchteten und auskristallisierten Bereiche (7, 7') des ersten Substrats (5), um die leitende Schicht (10) freizulegen, um mindestens einen Hohlraum (12, 12') zu bilden, dessen Seitenwände und dessen von der leitenden Schicht (10) eingenommener Boden die Form (3, 3') bilden.

2. Verfahren nach Anspruch 1, **dadurch gekennzeichnet, dass** das zweite Substrat (8) auf Siliziumbasis hergestellt ist.

3. Verfahren nach einem der vorhergehenden Ansprüche, **dadurch gekennzeichnet, dass** die leitende Schicht (10) durch Abscheiden einer Schicht aus einem metallischen Material, das aus der Gruppe Chrom, Titan und Gold ausgewählt ist, auf dem zweiten Substrat (8) gebildet wird.

4. Verfahren nach einem der vorhergehenden Ansprüche, **dadurch gekennzeichnet, dass** der Schritt e) zum Verbinden des ersten (5) und des zweiten (8) Substrats durch Verschweißen der leitenden Schicht (10) des zweiten Substrats (8) mit dem ersten Substrat (5) durchgeführt wird.

5. Verfahren nach einem der Ansprüche 1 bis 3, **dadurch gekennzeichnet, dass** der Schritt e) zum Verbinden des ersten Substrats (5) mit dem zweiten Substrat (8) durch Verschweißen des ersten Substrats (5) mit dem zweiten Substrat (8) mittels einer zwischen dem ersten Substrat (5) und der leitenden Schicht (10) vorgesehenen Harzschicht (16) durchgeführt wird.

6. Verfahren nach Anspruch 5, **dadurch gekennzeichnet, dass** Schritt f) einen Teilschritt f') zum Entfernen der Harzschicht (16) umfasst, die sich nach dem Entfernen der beleuchteten und auskristallisierten Bereiche (7, 7') des ersten Substrats (5) in dem Hohlraum (12, 12') gebildet hat, so dass die leitende Schicht (10) freigelegt wird.

7. Verfahren nach einem der vorhergehenden Ansprüche, **dadurch gekennzeichnet, dass** Schritt f) zum Entfernen der beleuchteten und auskristallisierten Bereiche (7, 7') des ersten Substrats (5) durch chemisches Ätzen, vorzugsweise durch Auflösen mit Flusssäure, durchgeführt wird.

8. Verfahren nach einem der vorhergehenden Ansprüche, **dadurch gekennzeichnet, dass** mehrere Formen (3, 3') auf demselben ersten Substrat (5) hergestellt werden.

9. Verfahren zum Herstellen eines mikromechanischen metallischen Teils (1, 1') durch galvanisches Abscheiden, **dadurch gekennzeichnet, dass** es die folgenden Schritte umfasst:
g) Herstellen einer Form (3, 3') des mikromechanischen Teils (1, 1') nach dem Verfahren zum Herstellen einer Form (3, 3') nach einem der Ansprüche 1 bis 8
h) Füllen der Form (3, 3') mit einem metallischen Material durch galvanisches Wachstum aus der leitenden Schicht (10) zum Bilden des mikromechanischen Teils (1, 1')
i) Lösen des in Schritt h) erhaltenen mikromechanischen Teils (1, 1') aus seiner Form (3, 3').

10. Formplatte (14), bestimmt zum Herstellen mindestens eines mikromechanischen Teils (1, 1') durch galvanisches Abscheiden, wobei die Formplatte (14) ein erstes Substrat (5) mit einer Dicke, die mindestens gleich der Höhe des mikromechanischen Teils (1, 1') ist, ein zweites Substrat (8), das fest mit dem ersten Substrat (5) verbunden ist, und mindestens eine leitende Schicht (10) umfasst, die sich zwischen dem ersten (5) und dem zweiten (8) Substrat befindet, wobei das erste Substrat (5) mindestens eine Form (3, 3') des mikromechanischen Teils (1, 1') umfasst, die aus einem Hohlraum (12, 12') besteht, der in dem ersten Substrat (5) gebildet ist und dessen Boden von der leitenden Schicht (10) eingenommen wird, wodurch die Abscheidung eines metallischen Materials durch galvanisches Wachstum in dem Hohlraum (12, 12') ermöglicht wird, um das mikromechanische Teil (3, 3') zu bilden, wobei die Formplatte (14) **dadurch gekennzeichnet ist, dass** das erste Substrat (5) aus lichtempfindlichem Glas besteht.

11. Formplatte (14) nach Anspruch 10, **dadurch gekennzeichnet, dass** das zweite Substrat (8) auf Siliziumbasis hergestellt ist.

12. Formplatte (14) nach einem der Ansprüche 10 und 11, **dadurch gekennzeichnet, dass** die leitende Schicht (10) eine Schicht aus einem metallischen Material ist, das aus der Gruppe ausgewählt ist, die Chrom, Titan und Gold umfasst.

13. Formplatte (14) nach einem der Ansprüche 10 bis 12, **dadurch gekennzeichnet, dass** sie eine Harzschicht (16) umfasst, die zwischen dem ersten Substrat (5) und der leitenden Schicht (10) vorgesehen ist.

## Claims

1. Process for manufacturing a mould (3, 3') comprising the following steps:
a) providing a first substrate (5) made of photosensitive glass of thickness of at least equal to the height of the mould (3, 3')
b) illuminating said first substrate (5) with UV rays through a mask having windows which correspond to the depression of the mould (3, 3') in order to create illuminated zones (7, 7')
c) carrying out a heat treatment on the first substrate (5) obtained in step b) in order to crystallize the illuminated zones (7, 7')
d) providing a second substrate (8) having at least one conductive layer (10) on its surface
e) joining the first substrate (5) obtained in step c) to the second substrate (8) so that the conductive layer (10) is located between the first substrate (5) and the second substrate (8)
f) removing the illuminated and crystallized zones (7, 7') of the first substrate (5) so as to uncover the conductive layer (10), in order to form at least one cavity (12, 12') the sidewalls of which and the bottom occupied by the conductive layer (10) of which form said mould (3, 3').

2. Process according to Claim 1, **characterized in that** the second substrate (8) is based on silicon.

3. Process according to either of the preceding claims, **characterized in that** the conductive layer (10) is formed by depositing, on the second substrate (8), a layer of a metal chosen from the group comprising chromium, titanium and gold.

4. Process according to one of the preceding claims, **characterized in that** the step e) of joining the first substrate (5) and second substrate (8) is carried out by soldering the conductive layer (10) of the second substrate (8) to the first substrate (5).

5. Process according to one of Claims 1 to 3, **characterized in that** the step e) of joining the first substrate (5) and second substrate (8) is carried out by soldering the first substrate (5) to the second substrate (8) by means of a resist layer (16) provided between the first substrate (5) and the conductive layer (10).

6. Process according to Claim 5, **characterized in that** step f) comprises a substep f') of removing the resist layer (16) uncovered in the cavity (12, 12') after removal of the illuminated and crystallized zones (7, 7') of the first substrate (5), so as to uncover the conductive layer (10).

7. Process according to one of the preceding claims, **characterized in that** the step f) of removing the illuminated and crystallized zones (7, 7') of the first substrate (5) is carried out by chemical etching, preferably with fluoridric acid.

8. Process according to one of the preceding claims, **characterized in that** a plurality of moulds (3, 3') are produced in the same first substrate (5).

9. Process for manufacturing by electroplating a metal micromechanical part (1, 1'), **characterized in that** it comprises the following steps:
g) manufacturing a mould (3, 3') of said micromechanical part (1, 1') using the process for manufacturing a mould (3, 3') according to one of Claims 1 to 8
h) filling the mould (3, 3') with a metal by galvanic growth from the conductive layer (10) in order to form said micromechanical part (1, 1')
i) releasing the micromechanical part (1, 1') obtained in step h) from its mould (3, 3').

10. Multi-mould plate (14) intended to manufacture at least one micromechanical part (1, 1') by electroplating, said multi-mould plate (14) includes a first substrate (5) of thickness at least equal to the height of the micromechanical part (1, 1'), a second substrate (8) securely fastened to the first substrate (5), at least one conductive layer (10) located between the first substrate (5) and second substrate (8), the first substrate (5) including at least one mould (3, 3') for the micromechanical part (1, 1'), which mould is formed by a cavity (12, 12') formed in said first substrate (5) and the bottom of which is occupied by the conductive layer (10), allowing a metal to be deposited by galvanic growth in said cavity (12, 12') in order to form said micromechanical part (3, 3'), said multi-mould (14) is **characterized in that** the first substrate (5) is made of photosensitive glass.

11. Multi-mould plate (14) according to Claim 10, **characterized in that** the second substrate (8) is based on silicon.

12. Multi-mould plate (14) according to either of Claims 10 and 11, **characterized in that** the conductive layer (10) is a layer of a metal chosen from the group comprising chromium, titanium and gold.

13. Multi-mould plate (14) according to one of Claims 10 to 12, **characterized in that** it comprises a resist layer (16) provided between the first substrate (5) and the conductive layer (10).
